# EUROPEAN PATENT SPECIFICATION

(11) **EP 1 250 215 B1**
(45) Date of publication and mention of the grant of the patent: **21.04.2004**
(21) Application number: 01946810.7
(22) Date of filing: 12.01.2001
(51) Int. Cl.: B24B 37/04, B24B 53/02, B24D 7/14, B24B 47/10

(54) **SYSTEM AND METHOD FOR CONTROLLED POLISHING AND PLANARIZATION OF SEMICONDUCTOR WAFERS**
VORRICHTUNG UND VEFAHREN FÜR DAS KONTROLLIERTE POLIEREN UND PLANARISIEREN VON HALBLEITERSCHLEIFEN
APPAREIL ET TECHNIQUE PERMETTANT DE MAITRISER LE POLISSAGE ET LA PLANARISATION DE TRANCHES DE SEMI-CONDUCTEUR

(30) Priority: 28.01.2000 US 493978
(43) Date of publication of application: 23.10.2002
(73) Proprietor: LAM RESEARCH CORPORATION, Fremont, CA 94538 (US)
(72) Inventor: Kistler, Rod, Los Gatos, CA 95032 (US); Gotkis, Yehiel, Fremont, CA 94536 (US)
(74) Representative: Bucks, Teresa Anne
(86) International application number: PCT/US2001/001044
(87) International publication number: WO 2001/054862

(56) References cited:
- EP-A- 0 754 525
- US-A- 5 441 444
- US-A- 5 632 873
- US-A- 5 709 593
- US-A- 5 736 427
- US-A- 5 895 270
- US-A- 6 010 538
- PATENT ABSTRACTS OF JAPAN vol. 2000, no. 04, 31 August 2000 (2000-08-31) & JP 2000 015557 A (EBARA CORP), 18 January 2000 (2000-01-18)
- PATENT ABSTRACTS OF JAPAN vol. 018, no. 130 (M-1570), 3 March 1994 (1994-03-03) & JP 05 318325 A (SONY CORP), 3 December 1993 (1993-12-03)

## Description

### FIELD OF THE INVENTION

The present invention relates to planarization of semiconductor wafers using a chemical mechanical planarization technique as known e.g. from document JP-A-2000 015 557. More particularly, the present invention relates to an improved system and method for planarizing semiconductor wafers in a controlled manner over a variable geometry contact area.

### BACKGROUND

Semiconductor wafers are typically fabricated with multiple copies of a desired integrated circuit design that will later be separated and made into individual chips. A common technique for forming the circuitry on a semiconductor wafer is photolithography. Part of photolithography process requires that a special camera focus on the wafer to project an image of the circuit on the wafer. The ability of the camera to focus on the surface of the wafer is often adversely affected by inconsistencies or unevenness in the wafer surface. This sensitivity is accentuated with the current drive for smaller, more highly integrated circuit designs which cannot tolerate certain nonuniformities within a particular die or between a plurality of dies on a wafer. Because semiconductor circuit on wafers are commonly constructed in layers, where a portion of a circuit is created on a first layer and conductive vias connect it to a portion of the circuit on the next layer, each layer can add or create topography on the wafer that must be smoothed out before generating the next layer. Chemical mechanical planarization (Oxide-CMP) techniques are used to planarize and polish each layer of a wafer. CMP (Metal-CMP) is also widely used to shape within-die metal plugs and wires, removing excess metal from the wafer surface and only leaving metal within the desired plugs and trenches on the wafer. Available CMP systems, commonly called wafer polishers, often use a rotating wafer holder that brings the wafer into contact with a polishing pad rotating in the plane of the wafer surface to be planarized. A chemical polishing agent or slurry containing microabrasives and surface modifying chemicals is applied to the polishing pad to polish the wafer. The wafer holder then presses the wafer against the rotating polishing pad and is rotated to polish and planarize the wafer. Some available wafer polishers use orbital motion, or a linear belt rather than a rotating surface to carry the polishing pad. In all instances, the surface of the wafer is often completely covered by, and in contact with, the polishing pad to simultaneously polish the entire surface. One drawback of polishing the entire surface simultaneously is that the various circuits on the wafer, even if the wafer begins the CMP process perfectly flat, may have a different response to the CMP process. This may be due to the different types of materials deposited on parts of the wafer or the density of materials on a certain portion of the wafer. Simultaneous polishing of the entire surface will often clear some spots of the wafer faster than others because of this differential, uneven rate of clearing and may result in overpolishing of certain areas of the wafer. Various material processes used in formation of wafers provide specific challenges to providing a uniform CMP polish to a wafer. One of the more recent processes used, the copper dual damascene process, can be particularly sensitive to the overpolishing that may occur in polishers that simultaneously polish the entire surface of a wafer. Also, the trends to process larger diameter wafers has introduced an additional level of difficulty to the CMP process by requiring uniformity over a greater surface area.

Accordingly, there is a need for a method and system of performing CMP that addresses these issues.

### BRIEF DESCRIPTION OF THE DRAWINGS

FIG. 1 is a side cut-away view of a semiconductor wafer polishing system according to a preferred embodiment;
FIG. 2 is a top plan view of a wafer carrier assembly suitable for use in the system of FIG. 1;
FIG. 3 is a sectional view taken along line 3-3 of FIG. 2;
FIG. 4 is an exploded sectional view of a polishing pad carrier assembly and tool changer suitable for use in the system of FIG. 1;
FIGS. 5A-5D illustrate top plan views of different embodiments of a surface of a pad dressing assembly suitable for use in the system of FIG. 1;
FIG. 6 is a block diagram illustrating the communication lines between the microprocessor and the individual components of the polisher of FIG. 1;
FIG. 7 is a top plan view illustrating the movement of the components of the system of FIG. 1; and
FIG. 8 is a diagram illustrating a wafer processing system incorporating the wafer polisher of FIG. 1.

### DETAILED DESCRIPTION OF THE PRESENTLY PREFERRED EMBODIMENTS

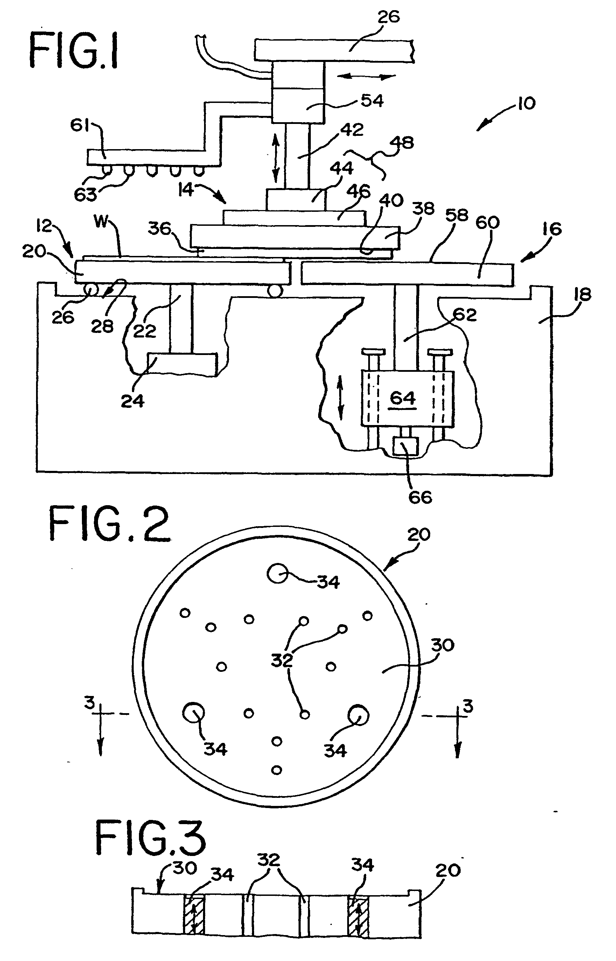

In order to address the drawbacks of the prior art described above, a wafer polisher is disclosed below that can provide improved polishing performance and flexibility, as well as avoid over-polishing and assist with improving polishing uniformity of wafers produced with difficult to planarize layers such as those produced using copper processes. A preferred embodiment of a wafer polisher 10 is illustrated in FIG. 1. The polisher 10 includes a wafer carrier assembly 12, a pad carrier assembly 14 and a pad dressing assembly 16. Preferably, the wafer carrier assembly 12 and pad dressing assembly 16 are mounted in a frame 18. The wafer carrier assembly includes a wafer head 20 mounted on a shaft 22 rotatably connected to a motor 24. In a preferred embodiment, the wafer head 20 is designed to maintain a rigid planar surface that will not flex or bend when polishing pressure is received from the pad carrier assembly 14. Preferably, a circular bearing 26, or other type of support, is positioned between the wafer head 20 and an upper surface 28 of the frame 18 along a circumference of the wafer head 20 in order to provide additional support to the wafer head 20. Alternatively, the wafer carrier assembly 20 may be constructed with a shaft 22 having sufficient strength to avoid any deflections.

The wafer head 20 of the wafer carrier assembly 12 is further described with respect to FIGS. 2 and 3. The wafer head 20 preferably has a wafer receiving region 30 for receiving and maintaining a semiconductor wafer in a fixed position during polishing. The wafer receiving area 30 may be a recessed area as shown in FIG. 3 or may be an area centered at the center of rotation of the wafer head 20. Any of a number of known methods for maintaining contact between the wafer and the wafer head 20 during CMP processing may be implemented. In a preferred embodiment, the wafer receiving area 30 of the head 20 includes a plurality of air passages 32 for providing a flow of air, or receiving a vacuum, useful in maintaining or releasing the wafer from the wafer head 20. A porous ceramic or metal material may also be used to allow for a vacuum to be applied to a wafer. Other methods of maintaining the wafer against the wafer carrier, for example adhesives, a circumferentially oriented clamp, or surface tension from a liquid, may be used. One or more wafer lifting shafts 34 are movably positioned between a recessed location within the wafer head and a position extending away from the wafer receiving area 30 of the head 20 to assist in loading and unloading a wafer from a wafer transport mechanism, such as a robot. Each wafer lifting shaft may be operated pneumatically, hydraulically, electrically, magnetically or through any other means. In another preferred embodiment, the wafer head 20 may be fabricated without any wafer lifting shafts 34 and wafers may be loaded or unloaded from the wafer head using a vacuum assisted method.

Referring again to FIG. 1, the pad carrier assembly 14 includes a polishing pad 36 attached to a pad support surface 40 of a pad carrier head 38. The polishing pad 36 may be any of a number of known polishing materials suitable for planarizing and polishing semiconductor wafers. The polishing pad may be the type of pad used in conjunction with abrasive slurry, such as the IC 1000 pad available from Rodel Corporation of Delaware. Alternatively, the pad may be constructed of a fixed abrasive material that does not require an abrasive containing slurry. Although the diameter of the polishing pad 36 is preferably equal to, or substantially the same as, the diameter of the wafer W, other diameter ratios of the polishing pad and wafer are contemplated. In one embodiment, the polishing pad size may be anywhere in the range of the size of a single die on the wafer to an area twice as large as that of the wafer. Pad dressing surfaces having a an area greater than that of the wafer may be advantageous to account for a wider range of motion of the polishing pad, for example in situations where the polishing pad is moved in a manner that would position the center of the polishing pad off of an imaginary line formed between the center of the wafer and the center of the pad dressing surface. In embodiments where more than a single pad dressing head are contemplated, the area of the pad dressing heads is preferably sufficient to condition and support the polishing pad used.

The pad carrier head 38 is preferably attached to a spindle 42 through male and female 44, 46 portions of a tool changer 48. The tool changer preferably allows for interchangeability between pad carrier heads 38 so that different CMP processes may be applied to the same wafer by changing wafer heads and any associated types of abrasive polishing chemistries.

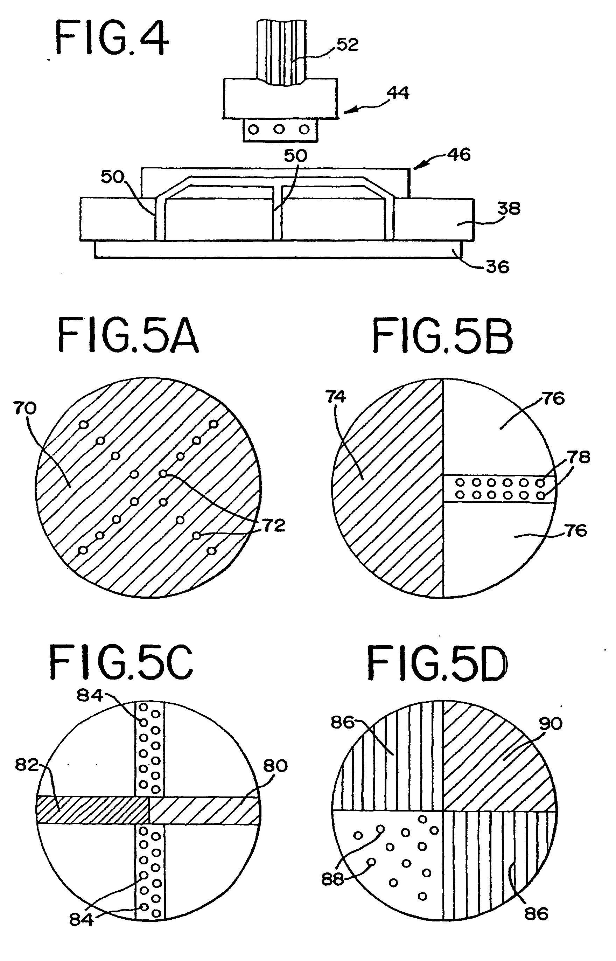

As shown in FIG. 4, a pad 36 may receive abrasive slurry through passages 50 from the pad carrier head 38 and tool changer 44, 46 that are fed by one or more slurries applied lines 52 that may be within the spindle 42. The spindle is rotatably mounted within a spindle drive assembly 54 mounted to a spindle transport mechanism 56. The transport mechanism may be any of a number of mechanical, electrical or pneumatic devices having a controllable reciprocating or orbital motion, or a rotating arm mechanism, that are capable of moving the polishing pad to a plurality of discrete positions on the wafer during a polishing operation.

The spindle drive assembly 54 is designed to rotate the polishing pad 36 on the polishing pad carrier head 38 and it is designed to allow for movement of the spindle to move the polishing pad towards or away from the plane of the wafer W as well as apply a totally controlled polishing pressure to the wafer during CMP processing. It also allows easy access to the pad carrier and facilities assembly automatic replacement of the polishing pad. A suitable spindle drive assembly, such as the one used in the TERES™ polisher available from Lam Research Corporation in Fremont, California, may be used to accomplish this task. The spindle transport mechanism 56 may be any of a number of mechanical or electrical devices capable of transporting the spindle in a direction coplanar to the wafer W being polished. In this manner, the polishing pad 36 may be precisely positioned and/or oscillated, if required, in a linear direction about a position along a radius of the wafer W.

A pad dressing assembly 16 is preferably positioned adjacent to the wafer carrier assembly and opposite the pad carrier assembly 14. The pad dressing assembly 16 is designed to provide in-situ and ex-situ conditioning and cleaning of the polishing pad 36.

In one embodiment, the size of the active surface 58 of the pad dressing assembly 16 is preferably substantially the same as the area of the polishing pad. The active surface of the pad dressing assembly may also be larger or smaller than the area of the polishing pad in other embodiments. Additionally, the pad dressing assembly may also consist of multiple rotatable surfaces in other embodiments.

Preferably, the pad dressing assembly 16 has a surface 58 coplanar with the surface of the wafer W being processed The size of the active area of the pad dressing assembly is at least as great as that of the polishing pad 36, consisting of a single or smaller multiple heads). The surface 58 of the pad dressing assembly 16 is affixed to a pad dressing head 60 attached to a shaft 62 rotatably mounted in a motor 64. In order to assist in maintaining the planarity of the pad dressing surface 58 with the wafer W, a plane adjustment mechanism 66 may be used to adjust the position of the pad dressing assembly 16.

In one embodiment, the plane adjustment mechanism 66 may be a mechanical device that may be loosened, adjusted to compensate for height variations, and retightened, between CMP processing runs. In one alternative embodiment, the plane adjustment mechanism may be an active mechanically, or electrically driven device, such as a spring or pneumatic cylinder, that continuously puts an upward pressure on the pad dressing head 60 such that the pressure of the pad carrier assembly 14 against the pad dressing surface 58 maintains a pad dressing surface in a coplanar relationship with the wafer W mounted on the wafer carrier assembly 12. In yet another embodiment, a three point balancing device, having three separately height adjustable shafts, may be used to adjust the plane of the pad dressing surface and/or the wafer carrier head. As with the wafer carrier assembly 12, the pad dressing head 60 may be supported by a circular bearing or may be supported by the shaft 62 alone.

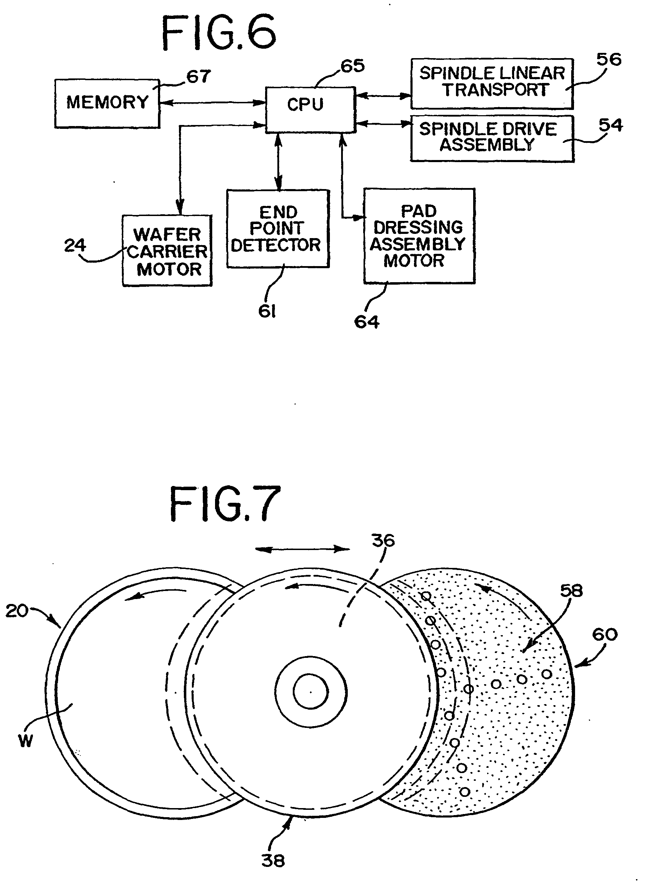

Referring to FIGS. 5A-D, several embodiments of preferred pad dressing surfaces positioned on the pad dressing head 60 are shown. In FIG. 5A, the pad dressing surface may be completely covered with a fixed abrasive media 70 such as alumina, ceria and diamond available from 3M and Diamonex. In addition, a plurality of orifices 72 for transporting a fluid, such as deionized water, slurry or other desired chemistry spray, are dispersed across the surface.

The active surface of the pad dressing assembly may consist of a single dressing feature, such as a diamond coated plate or pad, or may consist of a combination of several pieces of different materials. In other preferred embodiments, the surface of the pad dressing head is divided in sections and includes a set of various standard sized pad conditioning sections, such as a fixed abrasive unit, a brush and spray unit, sprayers and other types of known pad dressing services. Depending on the desired pad dressing performance, each section of the surface of the pad dressing head may have independently controllable actuators that provide for rotational and up/down motion, and a liquid supply port.

As shown in FIG. 5b, the pad dressing surface may have a fixed abrasive 74 on one half of the surface, a clean pad 76 on the opposite half of the surface, and an array of fluid dispensing orifices 78 positioned along the clean pad section. The clean pad may be a poromeric material such as Polytex available from Rodel Corporation. In another preferred embodiment, the pad dressing surface may contain a strip of diamond grit 80, a nylon brush 82 positioned along another radius and a plurality of fluid orifices 84 perpendicular to the strip of nylon brush and diamond media as shown in FIG. 5C. Another preferred embodiment is illustrated in FIG. 5D, wherein a fixed abrasive substance 86 is positioned on opposite quarters of the surface while a plurality of fluid orifices 88 and a clean pad 90 are each positioned on a respective one of the remaining two quarters of the surfaces. Any of a number of configurations of abrasive material to abrade and condition the pad, a fluid to rinse the pad, and/or clean pad materials may be utilized. Additionally, any suitable fixed abrasive or fluid may be used.

The polisher 10 of FIGS. 1-5 is preferably configured with the wafer carrier assembly and pad dressing assembly having a co-planar relationship between their respective surfaces. As provided above, the co-planarity may be manually adjusted or self-adjusting. Also, the pad dressing head and wafer carrier head are preferably positioned as close together radially as possible so that the maximum amount of polishing pad material will be conditioned. Preferably, the surface of the pad dressing head is large enough, and positioned close enough to the wafer carrier, such that the entire polishing pad is conditioned after one complete rotation of the pad. In other embodiments, multiple pad dressing devices may be used to condition the same or different portions of the pad. In these alternative pad dressing embodiments, the surface of each pad dressing assembly may be arrayed radially with respect to the wafer carrier head, or may be arrayed in any other desired fashion.

In a preferred embodiment, each of the wafer carrier, pad carrier, and pad dressing assemblies may be constructed having heads that are non-gimbaled. In another embodiment, the pad carrier head may be a gimbaled head, such as those commonly known in the industry, to compensate for minor inaccuracies in the alignment of the interacting wafer surface, polishing pad and pad dressing surface. Also, the wafer carrier head and pad dressing head are preferably oriented with their respective surfaces facing in an upward direction, while the pad carrier head faces downward. An advantage of this wafer up configuration is that it can assist in improved in-situ surface inspection, end point detection and direct supply of liquids to the wafer surface. In other embodiments, the wafer and pad dressing heads, and the opposing pad carrier head, may be oriented parallel to a non-horizontal plane, such as a vertical plane, or even completely reversed (i.e., polishing pad facing up and wafer and pad dressing surface facing down) depending on space and installation constraints.

As shown in FIG. 6, the polisher 10 is controllable by a microprocessor (CPU) 65 based on instructions stored in a programmable memory 67. The instructions may be a list of commands relating to wafer specific polishing schemes that are entered or calculated by a user based on a combination of operational parameters to be sensed or maintained by the various components of the polisher. These parameters may include rotational speed of the carrier heads for the pad, wafer and pad dressing components, position/force information from the spindle drive assembly 54, radial pad position information from the spindle linear transport mechanism 56, and polishing time as maintained by the CPU and adjusted in process by information from the end point detector 61. The CPU is preferably in communication with each of the different components of the polisher.

With reference to the polisher 10 described in FIGS. 1-6 above, operation of the polisher is described below. After a wafer is loaded onto the wafer carrier, the polishing pad is lowered by the spindle drive assembly such that polishing pad overlaps only a portion of the surface of the wafer as shown in FIG. 7. Although the polisher can be operated to completely cover the surface of the wafer with the pad, the pad is preferably only covering, and in contact with, a portion of the wafer surface at any given time. Also, a portion of the polishing pad that is not covering the wafer is preferably covering, and in contact with, the surface of the pad dressing assembly. Thus, as one portion of the polishing pad rotates and presses against a portion of the rotating wafer, another portion of the polishing pad is rotating against the rotating surface of the pad dressing assembly to clean and condition the polishing pad on each rotation of the pad. Preferably the entire polishing pad is utilized in this continuous process of polishing and pad conditioning.

Preferably, the polisher 10 is capable of addressing regional variations in uniformity on a wafer-by-wafer basis. This function is achieved by first obtaining profile information on each wafer and calculating a polishing strategy for the polisher to address the particular non-uniformities of each wafer. The wafer profile information may be obtained from earlier measurements determined in processing earlier layers of the particular wafer, or may be measured expressly before the wafer is processed. Any one of a number of known profile measurement techniques may be used to obtain the necessary profile data. For example, a resistance measurement using a four point probe may be taken at points from the center of the wafer to the edge to determine profile properties. These properties may be used in conjunction with the previously measured properties of the polishing pad (for example, the measured polishing response at various points along the radius of the polishing pad) to calculate the best polishing scheme (e.g., polishing pad path, rotational speed of the wafer and pad, downforce applied to the pad, and time at each point on the polishing path) and store these instructions in the polisher memory for execution by the CPU.

Prior to, and after, polishing the wafer, the wafer lifting shafts 38 in the wafer carrier assembly 12 are activated to lift the wafer from the wafer receiving surface and transfer the wafer to or from the wafer carrying robot. Also, during the CMP process on a particular wafer, it is preferred that the wafer, polishing pad, and pad dressing surface all rotate in the same direction. Other combinations of rotational directions are contemplated and rotational speed of the individual assemblies may vary and be varied purposefully during a particular polishing run.

Once the polishing scheme is determined and stored, and the wafer is properly mounted in the wafer carrier, polishing may progress according to the predetermined polishing scheme. The pad, wafer and pad dressing surface will all be rotated at a desired speed. Suitable rotational speeds for the pad, wafer and pad dressing surface may be in the range of 0 - 700 revolutions per minute (r.p.m.). Any combination of rotational speeds and rotational speeds of greater than 700 r.p.m. are also contemplated. The linear transport mechanism for the spindle will position the edge of the pad at the first point along the radius of the wafer and the spindle drive assembly will lower the pad until it reaches the surface of the wafer and the desired pressure is applied. The polishing pad preferably only covers a portion of the wafer and continues to polish the wafer until the desired polishing time has expired. Preferably, the process status inspection system, which may be an end point detector 61 (FIG. 1) having one or more transmitter/receiver nodes 63, communicates with the CPU to provide in-situ information on the polishing progress for the target region of the wafer and to update the original polishing time estimate. Any of a number of known surface inspection and end point detection methods (optical, acoustic, thermal, etc.) may be employed. While a predetermined polishing strategy may be applied to each individual wafer, the signal from surface inspection tool may be used for precise adjustment of the time spent by the polishing pad at each location.

After polishing the first region of the wafer, the linear index mechanism moves the polishing pad to the next position and polishes that region. The polishing pad preferably maintains contact with the surface of the wafer as it is moved to the next radial position. Additionally, while the polisher may move the polishing pad from a first position, where the edge of the polishing pad starts at the center of the wafer, to subsequent positions radially away from the center in consecutive order until the wafer edge is reached, the profile of a particular wafer may be best addressed by moving in other linear paths. For example the first polish operation may start with the edge of the polishing pad at a point in between the center and edge of the wafer and the polisher may move the polishing pad to positions along the wafer radius toward the edge, and finishing with a final polish with the edge of the pad at the center of the wafer.

During polishing, the polishing pad is preferably constantly in contact with the surface of the pad dressing assembly. The pad dressing assembly conditions the pad to provide a desired surface and cleans by-products generated by the polishing process. The abrasive material on the surface of the pad dressing assembly preferably activates the pad surface while pressurized deionized water or other suitable chemical cleanser is sprayed through the orifices in the surface and against the pad.

Using the CPU to monitor the pressure applied by the spindle to the pad carrier head and controllably rotate the pad carrier head and the wafer, the polishing process proceeds until the end point detector indicates that the polisher has finished with a region. Upon receiving information from the end point detector, the CPU instructs the spindle linear transport mechanism 56 to radially move the polishing pad with respect to the center of the wafer to draw the polishing pad away from the center of the wafer and focus on the next annular region of the wafer. Preferably, the pad and the wafer maintain contact while the pad is withdrawn radially towards the edge of the wafer. In a preferred embodiment, the spindle linear transport mechanism 56 may simply index in discrete steps movement of the pad. In another preferred embodiment, the spindle mechanism 56 may index between positions and oscillate back and forth in a radial manner about each index position to assist in smooth transitions between polish regions on the wafer.

In another embodiment, the linear spindle transport mechanism may move in discrete steps, maintain the spindle in a fixed radial position after each step and make use of a polishing pad that is offset from the center of rotation of the polishing pad carrier to provide an oscillating-type movement between the pad and the wafer. As is apparent from the figures, the polishing pad dressing not only maintains constant contact with the wafer, it also maintains constant contact with the surface of the pad dressing assembly. Each rotation of the polishing pad will bring it first across the wafer and then into contact with various portions of the surface of the pad dressing assembly.

The polisher 10 may be configured to allow for the pad to completely overlap the wafer, however the pad preferably indexes between various partially overlapping positions with respect to the wafer to assist in avoiding within wafer nonuniformity. Advantages of this configuration and process include the ability to focus the removal rate at various annular portions of the wafer to provide greater polish control and avoid over polish problems often associated with polishing an entire surface of a wafer simultaneously. Further, the partial overlapping configuration permits continuous, in-situ pad conditioning.

Although a single pad dressing assembly is shown, multiple pad dressing assemblies may also be implemented. An advantage of the present polisher 10 is that in-situ pad conditioning may be performed as well as in-situ end point detection based on the fact that the wafer and polishing pad preferably do not completely overlap. Additionally, by starting the overlap of the pad and wafer at a point no greater than the radius of the polishing pad, the polishing pad may be completely conditioned each rotation. Furthermore, cost savings may be achieved by fully utilizing the surface of the polishing pad. Unlike several prior art systems, where the polishing pad is significantly larger than the wafer being polished, the entire surface of the polishing pad is potentially utilized.

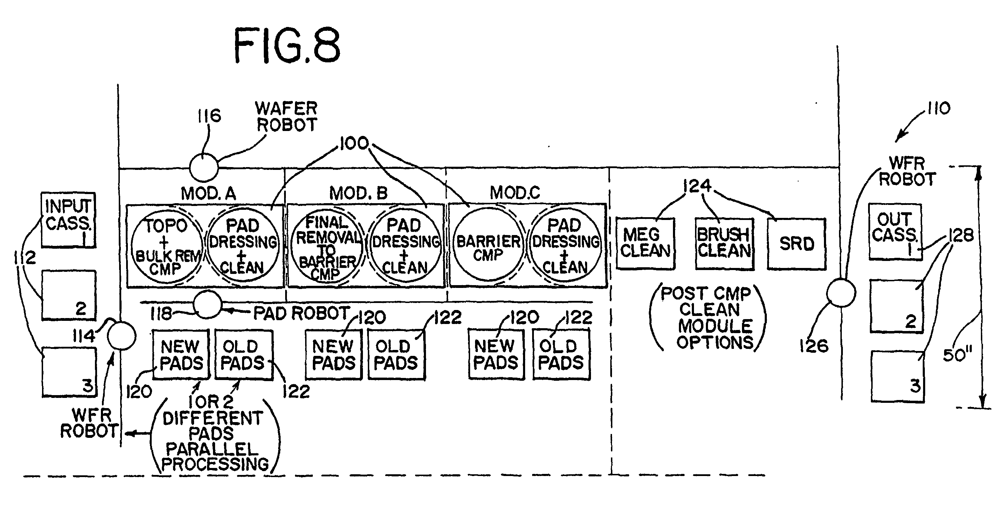

The polisher 10 shown in FIGS. 1-7 is used in the present invention as a module 100 in a larger wafer processing system 110 as shown in FIG. 8.

In the system of FIG. 8, multiple modules are linked in series to increase wafer throughput The wafer processing system 110 preferably is configured to receive semiconductor wafers loaded in standard input cassettes 112 that require planarization and polishing. A wafer transport robot 114, may be used to transfer individual wafers from the cassettes to the first module 100 for polishing. A second wafer transport robot may be used to transfer the wafer to the next module upon completion of processing at the first module as described with respect to the polisher 10 of FIG. 1. The system 110 may have as many modules 100 as desired to address the particular polishing needs of the wafers. For example, each module could be implemented with the same type of pad and slurry combination, or no slurry if fixed abrasive techniques are used, and each wafer would be partially planarized at each module such that the cumulative effect of the individual polishes would result in a completely polished wafer after the wafer receives its final partial polish at the last module.

Alternatively, different pads or slurries could be used at each module. As described above with respect to the polisher of FIG. 1, each polisher module 100 may change polishing pad carriers through the use of a tool changer. This additional flexibility is attainable in the system of FIG. 8 through the use of a pad robot 118 that may cooperate with the spindle drive assembly of each module to switch between pads automatically without the need to dismantle the entire system. Multi-compartment pad carrier head storage bins for fresh pads 120 and used pads 122 may be positioned adjacent each module to permit efficient changing of pad carrier heads attached to worn pads with pad carrier heads having fresh pads. Utilizing a cataloging mechanism, such as a simple barcode scanning technique, wafer pad carriers having different types of pads may be catalogued and placed at each module so that numerous combinations of pads may be assembled in the system 100.

After planarization, the second wafer robot 116 may pass the wafer on to various post CMP modules 124 for cleaning and buffing. The post CMP modules may be rotary buffers, double sided scrubbers, or other desired post CMP devices. A third wafer robot 126 removes each wafer from the post CMP modules and places them in the output cassettes when polishing and cleaning is complete.

## Claims

1. A semiconductor wafer polisher system (110) comprising:
a plurality of wafer polisher modules (100), each of the wafer polisher modules comprising:
a rotatable wafer carrier (20) having a wafer receiving surface (30) for releasably retaining a semiconductor wafer;
a rotatable polishing pad carrier (14) having a polishing pad (36) oriented substantially parallel to the wafer receiving surface (30) and configured to movably position the polishing pad (36) at a plurality of partially overlapping positions with respect to the semiconductor wafer, wherein the polishing pad (36) contacts and rotates against a portion of a surface of the semiconductor wafer; and
a rotatable pad dressing assembly (16) having a surface (58) comprising a polishing pad conditioning material, the surface (58) of the polishing pad dressing assembly (16) positioned substantially coplanar with the surface of the semiconductor wafer on the wafer carrier (20), such that when the rotatable pad dressing assembly (16) rotates and contacts a first portion of the polishing pad (36), a second portion of the pad polishes the semiconductor wafer;
and
a pad robot (118) positioned adjacent at least one of the plurality of wafer polishing modules, the pad robot configured to change a pad carrier head (38) of the rotatable polishing pad carrier (14) of the wafer polishing module (100) with a replacement pad carrier head stored in a pad carrier head storage compartment (120) adjacent the wafer polishing module.

2. The wafer polisher system (110) of claim 1, wherein the rotatable polishing pad carrier (14) comprises a linear index mechanism (56) configured to move the polishing pad (36) in a linear, radial direction with respect to the semiconductor wafer.

3. The wafer polisher system (110) of claim 2, wherein the polishing pad carrier head (38) is removably attached to a spindle (42).

4. The wafer polisher system (110) of claim 3, wherein the polishing pad carrier (14) further comprises a spindle drive assembly (54) connected with the index mechanism (56) and the spindle (42), the spindle drive assembly (54) configured to rotate the spindle (42) and move the polishing pad (36) against the semiconductor wafer.

5. The wafer polisher system (110) of claim 1, wherein the wafer receiving surface (30) of the rotatable wafer carrier (20) comprises a plurality of fluid orifices for receiving one of a vacuum and a pressurized fluid, wherein the semiconductor wafer is releasably attachable to the wafer receiving surface (30).

6. The wafer polisher system (110) of claim 4, wherein the index mechanism (56) is configured to move the polishing pad (36) to a plurality of partially overlapping positions with the surface of the wafer and the pad dressing surface (58) from a first position where the polishing pad (36) has a greater portion of the pad in contact with the surface of the wafer than with the pad dressing surface (58) to a second position where a greater portion of polishing pad (36) is positioned over the pad dressing surface (58) than the surface of the wafer.

7. The wafer polisher system (110) of claim 1, wherein the rotatable wafer carrier (20) comprises a support positioned to maintain the semiconductor wafer in fixed planar position, wherein the rotatable wafer carrier (20) does not flex in response to receiving a polishing pressure from the polishing pad carrier (14).

8. The wafer polisher system (110) of claim 7, wherein the support comprises a circular bearing (26).

9. The wafer polisher system (110) of claim 1, wherein at least one polisher module (100) comprises a polishing pad (36) constructed of a fixed abrasive material.

10. The wafer polisher system (110) of claim 1, wherein a first of the plurality of polisher modules (100) comprises a polishing pad (36) configured for use with an abrasive slurry and a second of the plurality of polisher modules (100) comprises a polishing pad constructed of a fixed abrasive material, whereby the first and second polisher modules have different pad types.

11. The wafer polisher system (110) of claim 1, wherein the polishing pad conditioning material of the pad dressing assembly (16) comprises a plurality of juxtaposed material sections, each of the material sections having a different material composition.

12. The wafer polisher system (110) of claim 1, wherein the surface of the polishing pad conditioning assembly further comprises at least one fluid transport orifice (78) positioned to transport a fluid against a polishing surface of the polishing pad (36).

13. The wafer polisher system (110) of claim 6, wherein the linear index mechanism (56) is operable to oscillate the polishing pad carrier in a linear fashion at each of the plurality of partially overlapping positions.

14. The wafer polisher system (110) of claim 1 further comprising a processor (65) in communication with the polishing pad carrier, an in-situ end point detector (61) positioned adjacent to the semiconductor wafer and a memory (67) containing instructions for the processor (65), wherein the processor (65) is operative to instruct the polishing pad carrier to linearly index based on information from the in-situ end point detector (61).

15. The wafer polisher system (110) of claim 1, wherein the rotatable wafer carrier (20) comprises a plurality of wafer lifting shafts (34) movably positionable between a first position, where the wafer lifting shafts (34) are recessed in the wafer carrier (20), and a second position, where the wafer lifting shafts (34) extend a distance away from the wafer receiving surface (30) of the rotatable wafer carrier (20).

16. A method of providing controlled regional polishing of a semiconductor wafer on a polisher module (100) in a wafer polisher system (110) as claimed in claim 1, the method comprising:
loading a semiconductor wafer on a wafer receiving surface (30) of a rotatable wafer carrier (20) and rotating the semiconductor wafer;
moving a polishing pad (36) mounted on a rotating polishing pad carrier (14) against the rotating semiconductor wafer and in a direction parallel to a surface of the semiconductor in a partially overlapping manner, wherein only a portion of the surface of the semiconductor wafer is in contact with the polishing pad (36); and
automatically replacing the polishing pad carrier head (38) of the polishing pad carrier (14) using a pad robot (118) positioned in the wafer polishing system (110), whereby a different polishing pad (36) is provided to the polisher module.

17. The method of claim 16, further comprising moving the polishing pad (36) to a second partially overlapping position with respect to the surface of the semiconductor wafer, wherein the polishing pad (36) is in continuous contact with the semiconductor wafer while the pad is moved.

18. The method of claim 16, further comprising moving the polishing pad (36) along a radius of the semiconductor wafer to a second partially overlapping position with respect to the surface of the semiconductor wafer, wherein the polishing pad (36) is in continuous contact with the semiconductor wafer while. the pad is moved.

19. The method of claim 18, further comprising rotating a pad dressing surface against a portion of the polishing pad (36) while the polishing pad (36) is in contact with a portion of the surface of the semiconductor wafer, whereby the polishing pad (36) is continuously reactivated by conditioning and cleaning during each rotation.

20. The method of claim 18, wherein the polishing pad (36) is oscillated over a predetermined path about each of the first and second partially overlapping positions.

21. The method of claim 16, wherein automatically replacing the polishing pad carrier head comprises the pad robot (118) cooperating with a tool changer (48) to remove a first polishing pad carrier head with a used polishing pad and attach a second polishing pad carrier head with a new polishing pad.

22. The method of claim 16, wherein automatically replacing the polishing pad carrier head comprises the pad robot (118) removing the polishing pad carrier head from the polisher module and placing the removed polishing pad carrier head in a pad carrier head storage container, removing a different polishing pad carrier head from the pad carrier head storage container and delivering the different polishing pad carrier head to the polisher module.

## Patentansprüche

1. Halbleiter-Wafer-Poliersystem (110), das umfasst:
eine Vielzahl von Wafer-Poliermodulen (100), wobei jedes der Wafer-Poliermodule umfasst:
einen drehbaren Wafer-Träger mit einer Wafer-Aufnahmefläche (30) zum lösbaren Halten des Halbleiter-Wafers;
einen drehbaren Polierscheiben-Träger (14) mit einer Polierscheibe (36), die im Wesentlichen parallel zu der Wafer-Aufnahmefläche (30) ausgerichtet und so ausgeführt ist, dass die Polierscheibe (36) beweglich an einer Vielzahl teilweise überlappender Positionen in Bezug auf den Halbleiter-Wafer positioniert wird, wobei die Polierscheibe (36) mit einem Teil einer Oberfläche des Halbleiter-Wafers in Kontakt kommt und sich daran dreht; und
eine drehbare Scheiben-Abrichtbaugruppe (16), die eine Fläche (58) hat, die ein Polierscheiben-Aufbereitungsmaterial umfasst, wobei die Fläche (58) der Polierscheiben-Abrichtbaugruppe (16) im Wesentlichen koplanar zu der Oberfläche des Halbleiter-Wafers auf dem Wafer-Träger (20) angeordnet ist, so dass, wenn sich die drehbare Scheiben-Abrichtbaugruppe (16) dreht und mit einem ersten Teil der Polierscheibe (36) in Kontakt kommt, ein zweiter Teil der Scheibe den Halbleiter-Wafer poliert; und
einen Scheiben-Roboter (118), der an wenigstens eines der Vielzahl von Wafer-Poliermodulen angrenzend angeordnet ist, wobei der Scheiben-Roboter so ausgeführt ist, dass er einen Scheiben-Trägerkopf (38) des drehbaren Polierscheiben-Trägers (14) des Wafer-Poliermoduls (100) gegen einen Ersatz-Scheiben-Trägerkopf austauscht, der in einem Scheiben-Trägerkopf-Aufbewahrungsfach (120) an das Wafer-Poliermodul angrenzend aufbewahrt wird.

2. Wafer-Poliersystem (110) nach Anspruch 1, wobei der drehbare Polierscheiben-Träger (14) einen Linear-Rückmechanismus (56) umfasst, der so ausgeführt ist, dass er die Polierscheibe (36) in einer linearen, radialen Richtung in Bezug auf den Halbleiter-Wafer bewegt.

3. Wafer-Poliersystem (110) nach Anspruch 2, wobei der Polierscheiben-Trägerkopf (38) abnehmbar an einer Spindel (42) angebracht ist.

4. Wafer-Poliersystem (110) nach Anspruch 3, wobei der Polierscheiben-Träger (14) des Weiteren eine Spindel-Antriebsbaugruppe (54) umfasst, die mit dem Rückmechanismus (56) und der Spindel (42) verbunden ist, wobei die Spindel-Antriebsbaugruppe (54) so ausgeführt ist, dass sie die Spindel (42) dreht und die Polierscheibe (36) an den Halbleiter-Wafer bewegt.

5. Wafer-Poliersystem (110) nach Anspruch 1, wobei die Wafer-Aufnahmefläche (30) des drehbaren Wafer-Trägers (20) eine Vielzahl von Fluiddüsen zur Aufnahme eines Vakuums oder eines Druckfluids umfasst, und wobei der Halbleiter-Wafer lösbar an der Wafer-Aufnahmefläche (30) angebracht werden kann.

6. Wafer-Poliersystem (110) nach Anspruch 4, wobei der Rückmechanismus (56) so ausgeführt ist, dass er die Polierscheibe (36) an eine Vielzahl teilweise überlappender Positionen zu der Oberfläche des Wafers und der Scheiben-Abrichtfläche (58) von einer ersten Position, an der ein größerer Teil der Polierscheibe (36) mit der Oberfläche des Wafers als mit der Scheiben-Abrichtfläche (58) in Kontakt ist, an eine zweite Position bewegt, an der ein größerer Teil der Polierscheibe (36) über der Scheiben-Abrichtfläche (58) als über der Oberfläche des Wafers positioniert ist.

7. Wafer-Poliersystem (110) nach Anspruch 1, wobei der drehbare Wafer-Träger (20) eine Trageinrichtung umfasst, die so angeordnet ist, dass der Halbleiter-Wafer in unveränderlicher planer Position gehalten wird, wobei sich der drehbare Wafer-Träger (20) in Reaktion auf die Aufnahme eines Polierdrucks von dem Polierscheiben-Träger (14) nicht biegt.

8. Wafer-Poliersystem (110) nach Anspruch 7, wobei die Trageeinrichtung ein kreisförmiges Lager (26) umfasst.

9. Wafer-Poliersystem (110) nach Anspruch 1, wobei wenigstens ein Poliermodul (100) eine Polierscheibe (36) umfasst, die aus fixierbarem Schleifmaterial besteht.

10. Wafer-Poliersystem (110) nach Anspruch 1, wobei ein erstes der Vielzahl von Poliermodulen (100) eine Polierscheibe (36) umfasst, die für den Einsatz mit einer schleifenden Aufschlämmung ausgeführt ist, und ein zweites der Vielzahl von Poliermodulen (100) eine Schleifscheibe umfasst, die aus einem fixierten Schleifmaterial besteht, so dass das erste und das zweite Poliermodul unterschiedliche Scheibentypen haben.

11. Wafer-Poliersystem (110) nach Anspruch 1, wobei das Polierscheiben-Aufbereitungsmaterial der Scheiben-Abrichtbaugruppe (16) eine Vielzahl nebeneinander angeordneter Materialabschnitte umfasst, und jeder der Materialabschnitte eine andere Materialzusammensetzung hat.

12. Wafer-Poliersystem (110) nach Anspruch 1, wobei die Oberfläche der Polierscheiben-Aufbereitungsbaugruppe des Weiteren wenigstens eine Fluidtransportdüse (78) umfasst, die so angeordnet ist, dass sie ein Fluid auf eine Polierfläche der Polierscheibe (36) transportiert.

13. Wafer-Poliersystem (110) nach Anspruch 6, wobei der lineare Rückmechanismus (56) so betätigt werden kann, dass der Polierscheiben-Träger an jeder der Vielzahl teilweise überlappender Positionen linear hin- und herbewegt werden kann.

14. Wafer-Poliersystem (110) nach Anspruch 1, das des Weiteren einen Prozessor (65), der mit dem Polierscheiben-Träger in Verbindung steht, einen In-Situ-Endpunktdetektor (61), der an den Halbleiter-Wafer angrenzend angeordnet ist, und einen Speicher (67) umfasst, der Befehle für den Prozessor (65) enthält, wobei der Prozessor (65) so arbeitet, dass er den Polierscheiben-Träger auf Basis von Informationen von dem In-Situ-Endpunktdetektor (61) anweist, linear zu rücken.

15. Wafer-Poliersystem (110) nach Anspruch 1, wobei der drehbare Wafer-Träger (20) eine Vielzahl.von Wafer-Hebewellen (34) umfasst, die beweglich zwischen einer ersten Position, in der die Wafer-Hebewellen (34) in den Wafer-Träger (20) eingezogen sind, und einer zweiten Position angeordnet werden kann, in der die Wafer-Hebewellen (34) sich in einem Abstand von der Wafer-Aufnahmefläche (30) des drehbaren Wafer-Trägers (20) erstrecken.

16. Verfahren, mit dem gesteuertes örtlich begrenztes Polieren eines Halbleiter-Wafers auf einem Poliermodul (100) in einem Wafer-Poliersystem (110) nach Anspruch 1 ermöglicht wird, wobei das Verfahren umfasst:
Auflegen eines Halbleiter-Wafers auf eine Wafer-Aufnahmefläche (30) eines drehbaren Wafer-Trägers (20) und Drehen des Halbleiter-Wafers;
Bewegen einer Polierscheibe (36), die an einem sich drehenden Polierscheiben-Träger (14) angebracht ist, teilweise überlappend an dem sich drehenden Halbleiter-Wafer und in einer Richtung parallel zu einer Oberfläche des Halbleiters, wobei nur ein Teil der Oberfläche des Halbleiter-Wafers mit der Polierscheibe (36) in Kontakt ist; und
automatisches Ersetzen des Polierscheiben-Trägerkopfes (38) des Polierscheiben-Trägers (14) unter Verwendung eines Scheiben-Roboters (118), der in dem Wafer-Poliersystem (110) angeordnet ist, so dass das Polier-Modul eine andere Polierscheibe (36) erhält.

17. Verfahren nach Anspruch 16, das des Weiteren das Bewegen der Polierscheibe (36) an eine zweite teilweise überlappende Position in Bezug auf die Oberfläche des Halbleiter-Wafers umfasst, wobei die Polierscheibe (36) kontinuierlich mit dem Halbleiter-Wafer in Kontakt ist, während die Scheibe bewegt wird.

18. Verfahren nach Anspruch 16, das des Weiteren das Bewegen der Polierscheibe (36) entlang eines Radius des Halbleiter-Wafers an eine zweite teilweise überlappende Position in Bezug auf die Oberfläche des Halbleiter-Wafers umfasst, wobei die Polierscheibe (36) kontinuierlich mit dem Halbleiter-Wafer in Kontakt ist, während die Scheibe bewegt wird.

19. Verfahren nach Anspruch 18, das des Weiteren das Drehen einer Scheiben-Abrichtfläche an einem Teil der Polierscheibe (36) umfasst, während die Polierscheibe (36) mit einem Teil der Oberfläche des Halbleiter-Wafers in Kontakt ist, so dass die Polierscheibe (36) während jeder Drehung kontinuierlich durch Aufbereiten und Reinigen aufgearbeitet wird.

20. Verfahren nach Anspruch 18, wobei die Polierscheibe (36) um die erste und die zweite teilweise überlappende Position über einen vorgegebenen Weg hin- und herbewegt wird.

21. Verfahren nach Anspruch 16, wobei das automatische Ersetzen des Polierscheiben-Trägerkopfes umfasst, dass der Scheiben-Roboter (118) mit einem Werkzeugwechsler (48) zusammenwirkt, um einen ersten Polierscheiben-Trägerkopf mit einer verbrauchten Polierscheibe zu entfernen und einen zweiten Polierscheiben-Trägerkopf mit einer neuen Polierscheibe anzubringen.

22. Verfahren nach Anspruch 16, wobei das automatischen Austauschen des Polierscheiben-Trägerkopfes umfasst, dass der Scheiben-Roboter (118) den Polierscheiben-Träger von dem Poliermodul entfernt und den entfernten Polierscheiben-Trägerkopf in einen Scheiben-Trägerkopf-Aufbewahrungsbehälter legt, einen anderen Polierscheiben-Trägerkopf aus dem Scheiben-Trägerkopf-Aufbewahrungsbehälter entnimmt und den anderen Polierscheiben-Trägerkopf dem Poliermodul zuführt.

## Revendications

1. Système de polissage de tranche de semi-conducteur (110) comprenant :
une pluralité de modules de polissage de tranche (100), chacun des modules de polissage de tranche comprenant :
un porteur de tranche rotatif (20) ayant une surface de réception de tranche (30) pour retenir avec possibilité de déblocage une tranche de semi-conducteur ;
un porteur de tampon de polissage rotatif (14) ayant un tampon de polissage (36) orienté de manière sensiblement parallèle à la surface de réception de tranche (30) et configuré pour positionner de manière amovible le tampon de polissage (36) à une pluralité de positions avec recouvrement partiel par rapport à la tranche de semi-conducteur, dans lequel le tampon de polissage (36) entre en contact et tourne autour d'une partie d'une surface de la tranche de semi-conducteur ; et
un assemblage de dressage du tampon rotatif (16) ayant une surface (58) comprenant un matériau de conditionnement du tampon de polissage, la surface (58) de l'assemblage de dressage du tampon de polissage (16) positionnée de manière sensiblement coplanaire avec la surface de la tranche de semi-conducteur sur le porteur de tranche (20), de sorte que lorsque l'assemblage de dressage de tampon rotatif (16) tourne et entre en contact avec une première partie du tampon de polissage (36), une deuxième partie du tampon polit la tranche de semi-conducteur ;
et
un robot de tamponnage (118) positionné adjacent à au moins un de la pluralité des modules de polissage de tranche, le robot de tamponnage configuré pour échanger une tête de porteur de tampon (38) du porteur de tampon de polissage rotatif (14) du module de polissage de tranche (100) avec une tête de porteur de tampon de remplacement stockée dans un compartiment de stockage de têtes de porteur de tampon (120) adjacent au module de polissage de tranche.

2. Système de polissage de tranche (110) selon la revendication 1, dans lequel le porteur du tampon de polissage rotatif (14) comprend un mécanisme d'indexage linéaire (56) configuré pour déplacer le tampon de polissage (36) dans une direction radiale linéaire par rapport à la tranche de semi-conducteur.

3. Système de polissage de tranche (110) selon la revendication 2, dans lequel la tête de porteur du tampon de polissage (38) est attachée de manière amovible à une broche (42).

4. Système de polissage de tranche (110) selon la revendication 3, dans lequel le porteur du tampon de polissage (14) comprend en outre un assemblage d'entraînement de broche (54) connecté au mécanisme d'indexage (56) et à la broche (42), l'assemblage d'entraînement de broche (54) étant configuré pour tourner la broche (42) et déplacer le tampon de polissage (36) contre la tranche de semi-conducteur.

5. Système de polissage de tranche (110) selon la revendication 1, dans lequel la surface de réception de la tranche (30) du porteur de tranches rotatif (20) comprend une pluralité d'orifices de fluides pour recevoir soit du vide, soit un fluide pressurisé, dans lequel la tranche de semi-conducteur peut s'attacher de manière détachable à la surface de réception de la tranche (30).

6. Système de polissage de tranche (110) selon la revendication 4, dans lequel le mécanisme d'indexage (56) est configuré pour déplacer le tampon de polissage (36) vers une pluralité de positions en recouvrement partiel avec la surface de la tranche et la surface de dressage du tampon (58) depuis une première position où le tampon de polissage (36) a une surface de tampon plus grande par rapport à la surface de la tranche que par rapport à la surface de dressage de tampon (58) vers une deuxième position où une partie plus grande du tampon de polissage (36) est positionnée au-dessus de la surface de dressage du tampon (58) que la surface de la tranche.

7. Système de polissage de tranche (110) selon la revendication 1, dans lequel le porteur de tranche rotatif (20) comprend un support positionné pour maintenir la tranche de semi-conducteur dans une position planaire fixe, dans lequel le porteur de tranche rotatif (20) ne fléchit pas en réponse à la réception d'une pression de polissage exercée depuis le porteur du tampon de polissage (14).

8. Système de polissage de tranche (110) selon la revendication 7, dans lequel le support comprend un coussinet circulaire (26).

9. Système de polissage de tranche (110) selon la revendication 1, dans lequel au moins un module de polissage (100) comprend un tampon de polissage (36) constitué d'un matériau abrasif fixe.

10. Système de polissage de tranche (110) selon la revendication 1, dans lequel un premier de la pluralité de modules de polissage (100) comprend un tampon de polissage (36) configuré pour l'utilisation avec une pâte d'émeri et un deuxième de la pluralité des modules de polissage (100) comprend un tampon de polissage constitué d'un matériau abrasif fixe, moyennant quoi les premier et deuxième modules de polissage ont différents types de tampon.

11. Système de polissage de tranche (110) selon la revendication 1, dans lequel le matériau de conditionnement du tampon de polissage de l'assemblage de dressage du tampon (16) comprend une pluralité de sections de matériaux juxtaposés, chacune des sections de matériaux ayant une composition de matériaux différente.

12. Système de polissage de tranche (110) selon la revendication 1, dans lequel la surface de l'assemblage de l'assemblage de conditionnement du tampon de polissage comprend en outre au moins un orifice de transport de fluide (78) positionné pour transporter un fluide contre une surface de polissage du tampon de polissage (36).

13. Système de polissage de tranche (110) selon la revendication 6, dans lequel le mécanisme d'indexage linéaire (56) peut être exploité pour faire osciller le porteur du tampon de polissage d'une manière linéaire pour chacun de la pluralité de positions en recouvrement partiel.

14. Système de polissage de tranche (110) selon la revendication 1, comprenant en outre un processeur (65) en communication avec le porteur du tampon de polissage, un détecteur de point final in situ (61), positionné adjacent à la tranche de semi-conducteur et une mémoire (67) contenant des instructions pour le processeur (65), dans lequel le processeur (65) fonctionne pour commander le porteur du tampon de polissage à un indexage linéaire basé sur des informations provenant d'un détecteur de point final in situ (61).

15. Système de polissage de tranche (110) selon la revendication 1, dans lequel le porteur de tranche rotatif (20) comprend une pluralité de tiges de levage de la tranche (34), pouvant être positionné entre une première position, où les tiges de levage de tranche (34) sont nichées dans le porteur de tranche (20), et une deuxième position, où les tiges de levage de tranche (34) s'étendent à une certaine distance de la surface de réception de tranche (30) du porteur de tranche rotatif (20).

16. Procédé pour fournir le polissage local contrôlé d'une tranche de semi-conducteur sur un module de polissage (100) dans un système de polissage de tranche (110), selon la revendication 1, le procédé comprenant :
le chargement d'une tranche de semi-conducteur sur une surface de réception de tranche (30) d'un porteur de tranche rotatif (20) et la rotation de la tranche de semi-conducteur ;
le déplacement d'un tampon de polissage (36) monté sur un porteur de tampon de polissage rotatif (14) contre la tranche de semi-conducteur rotatif et dans une direction parallèle à une surface du semi-conducteur, en recouvrement partiel, dans lequel seule une partie de la surface de la tranche de semi-conducteur est en contact avec le tampon de polissage (36) ; et
le remplacement automatique de la tête de porteur du tampon de polissage (38) du porteur du tampon de polissage (14) en utilisant un robot de tamponnage (118) positionné dans le système de polissage de tranche (110), moyennant quoi un tampon de polissage différent (36) est fourni au module de polissage.

17. Procédé selon la revendication 16, comprenant en outre le déplacement du tampon de polissage (36) vers une deuxième position en recouvrement partiel par rapport à la surface de la tranche de semi-conducteur, dans lequel le tampon de polissage (36) est en contact continu avec la tranche de semi-conducteur pendant que le tampon est déplacé.

18. Procédé selon la revendication 16, comprenant en outre le déplacement du tampon de polissage (36) le long d'un rayon de la tranche de semi-conducteur vers une deuxième position en recouvrement partiel par rapport à la surface de la tranche de semi-conducteur, dans lequel le tampon de polissage (36) est en contact continu avec la tranche de semi-conducteur pendant que le tampon est déplacé.

19. Procédé selon la revendication 18, comprenant en outre la rotation d'une surface de dressage de tampon contre une partie du tampon de polissage (36) tandis que le tampon de polissage (36) est en contact avec une partie de la surface de la tranche de semi-conducteur, moyennant quoi le tampon de polissage (36) est continuellement réactivé par le conditionnement et le nettoyage pendant chaque rotation.

20. Procédé selon la revendication 18, dans lequel le tampon de polissage (36) est mis en oscillation au-dessus d'une voie prédéterminée autour de chacune des première et deuxième positions se recouvrant partiellement.

21. Procédé selon la revendication 16, dans lequel le remplacement automatique de la tête de porteur du tampon de polissage comprend la coopération du robot de tamponnage (118) avec un échangeur d'outils (48) pour enlever une première tête de porteur de tampon de polissage, avec un tampon de polissage usé, et attacher une deuxième tête de porteur de tampon de polissage avec un nouveau tampon de polissage.

22. Procédé selon la revendication 16, dans lequel le remplacement automatique de la tête de porteur du tampon de polissage comprend le retrait par le robot de tamponnage (118) de la tête de porteur du tampon de polissage du module de polissage en plaçant la tête de porteur du tampon de polissage enlevée dans un conteneur de stockage pour tête de porteur de tampon, le retrait d'une tête de porteur de tampon de polissage différente du conteneur de stockage pour tête de porteur de tampon et la livraison de la tête de porteur de tampon de polissage différente au module de polissage.
